# EUROPEAN PATENT APPLICATION

(11) **EP 3 951 642 A1**
(43) Date of publication of application: **09.02.2022**
(21) Application number: 19924145.6
(22) Date of filing: 30.10.2019
(51) Int. Cl.: G06K 9/00

(54) **DISPLAY SCREEN ASSEMBLY AND ELECTRONIC DEVICE**

(30) Priority: 11.04.2019 CN 201910290385
(71) Applicant: GUANGDONG OPPO MOBILE TELECOMMUNICATIONS CORP., LTD., Dongguan, Guangdong 523860 (CN)
(72) Inventor: JIA, Yuhu, Dongguan, Guangdong 523860 (CN)
(74) Representative: Manitz Finsterwald Patent- und Rechtsanwaltspartnerschaft mbB
(86) International application number: PCT/CN2019/114464
(87) International publication number: WO 2020/206992

(57) **Abstract**

A display assembly and an electronic device are provided in the disclosure. The display assembly includes an optical sensor and a screen assembly which are stacked. The screen assembly is configured to emit a first optical signal toward one side away from the optical sensor. The optical sensor is configured to collect a fingerprint image of a target object according to a second optical signal obtained through reflection of the first optical signal. Components in the screen assembly, with light transmittance smaller than preset light transmittance, are at least partially stacked, to improve accuracy of the optical sensor in recognizing the fingerprint image. By adopting the display assembly of the disclosure, accuracy of fingerprint recognition can be improved.

## Description

### TECHNICAL FIELD

This disclosure relates to the field of electronic technologies, and particularly to a display assembly and an electronic device.

### BACKGROUND

In under-screen fingerprint sensor-based fingerprint recognition, lights emitted by an organic light-emitting diode (OLED) screen illuminate a finger on a surface of the screen, and then pass through various layers of a glass after being reflected by the finger, and finally reach the under-screen fingerprint sensor. The under-screen fingerprint sensor can perform personal identification by performing comparison of overall feature points and local feature points of different fingerprints. Generally, in the related art, a performance of the under-screen fingerprint sensor is improved by reducing a distance between the fingerprint sensor and a cover plate as much as possible, for example, reducing the thickness of the cover plate or reducing the thickness of an upper glass and/or a lower glass of the OLED screen, which however reduces an anti-dropping performance of the screen. Moreover, if the glass of the OLED screen has a relatively small thickness, a production yield will be affected and the glass is easy to break. Therefore, how to improve accuracy of the under-screen fingerprint sensor in fingerprint recognition has become a new challenge.

### SUMMARY

In implementations of the disclosure, a display assembly is provided. The display assembly includes an optical sensor and a screen assembly which are stacked. The screen assembly is configured to emit a first optical signal toward one side away from the optical sensor. The optical sensor is configured to collect a fingerprint image of a target object according to a second optical signal obtained through reflection of the first optical signal. Components in the screen assembly, with light transmittance smaller than preset light transmittance, are at least partially stacked, to improve accuracy of the optical sensor in recognizing the fingerprint image.

In implementations of the disclosure, a display assembly is further provided. The display assembly includes an optical sensor and a screen assembly which are stacked. The screen assembly has a display area corresponding to the optical sensor. The screen assembly is configured to emit a first optical signal toward one side away from the optical sensor. The optical sensor is configured to collect a fingerprint image of a target object according to a second optical signal obtained through reflection of the first optical signal. Components in the screen assembly, with light transmittance smaller than preset light transmittance, are at least partially stacked; or, the screen assembly further includes an adjustment layer which has a refractive index greater than a preset refractive index, to improve accuracy of the optical sensor in recognizing the fingerprint image, where the preset refractive index is equal to a refractive index of nitrogen.

In implementations of the disclosure, an electronic device is further provided. The electronic device includes a display assembly. The display assembly includes an optical sensor and a screen assembly which are stacked. The screen assembly has a display area corresponding to the optical sensor. The screen assembly is configured to emit a first optical signal toward one side away from the optical sensor. The optical sensor is configured to collect a fingerprint image of a target object according to a second optical signal obtained through reflection of the first optical signal. Components in the screen assembly, with light transmittance smaller than preset light transmittance, are at least partially stacked; or, the screen assembly further includes an adjustment layer which has a refractive index greater than a preset refractive index, to improve accuracy of the optical sensor in recognizing the fingerprint image, where the preset refractive index is equal to a refractive index of nitrogen.

### BRIEF DESCRIPTION OF THE DRAWINGS

In order to describe technical solutions of implementations of the disclosure more clearly, the following will give a brief description of accompanying drawings used for describing the implementations. Apparently, accompanying drawings described below are merely some implementations of the disclosure. Those of ordinary skill in the art can also obtain other accompanying drawings based on the accompanying drawings described below without creative efforts.
FIG. 1 is a schematic structural diagram illustrating a display assembly according to a first implementation.
FIG. 2 is a schematic structural diagram illustrating a display assembly according to a second implementation.
FIG. 3 is a schematic structural diagram illustrating a display assembly according to a third implementation.
FIG. 4 is a schematic structural diagram illustrating a display assembly according to a fourth implementation.
FIG. 5 is a schematic structural diagram illustrating a display assembly according to a fifth implementation.
FIG. 6 is a schematic structural diagram illustrating a display assembly according to a sixth implementation.
FIG. 7 is a schematic structural diagram illustrating a display assembly according to a seventh implementation.
FIG. 8 is a schematic structural diagram illustrating a display assembly according to an eighth implementation.
FIG. 9 is a schematic diagram illustrating a driving circuit of a light-emitting unit of a display assembly in the disclosure.
FIG. 10 is a schematic structural diagram illustrating a display assembly according to a ninth implementation.
FIG. 11 is a schematic structural diagram illustrating a display assembly according to a tenth implementation.
FIG. 12 is a schematic structural diagram illustrating a display assembly according to an eleventh implementation.
FIG. 13 is a schematic structural diagram illustrating a display assembly according to a twelfth implementation.
FIG. 14 is a schematic structural diagram illustrating a display assembly according to a thirteenth implementation.
FIG. 15 is a schematic structural diagram illustrating an electronic device according to a first implementation.
FIG. 16 is a schematic structural diagram illustrating an electronic device according to a second implementation.

### DETAILED DESCRIPTION

In an aspect of the disclosure, a display assembly is provided. The display assembly includes an optical sensor and a screen assembly which are stacked. The screen assembly is configured to emit a first optical signal toward one side away from the optical sensor. The optical sensor is configured to collect a fingerprint image of a target object according to a second optical signal obtained through reflection of the first optical signal. Components in the screen assembly, with light transmittance smaller than preset light transmittance, are at least partially stacked, to improve accuracy of the optical sensor in recognizing the fingerprint image.

In a first implementation, the screen assembly includes a substrate, a thin-film transistor layer, and a light-emitting unit which are stacked. The substrate is disposed adjacent to the optical sensor. The thin-film transistor layer includes a first metal layer and a second metal layer which are insulated from each other. The light-emitting unit includes a third metal layer. At least two projections of the first metal layer, the second metal layer, and the third metal layer on the substrate are partially overlapped.

In a second implementation with reference to the first implementation, the first metal layer includes a gate. The thin-film transistor layer further includes an active layer and an insulating layer. The active layer, the insulating layer, and the gate are stacked sequentially and the active layer is disposed adjacent to the substrate, or, the gate, the insulating layer, and the active layer are stacked sequentially and the gate is disposed adjacent to the substrate.

In a third implementation with reference to the first implementation, the screen assembly further includes an encapsulation layer. The light-emitting unit further includes a light-emitting layer and a cathode layer. The third metal layer includes an anode layer. The light-emitting layer is sandwiched between the anode layer and the cathode layer. A protective layer is disposed between the cathode layer and the encapsulation layer. The protective layer is configured to provide an anti-oxidation protection for the light-emitting layer.

In a fourth implementation with reference to the second implementation or the third implementation, the screen assembly further includes buffer foam. The buffer foam is disposed between the optical sensor and the substrate. The buffer foam defines an opening, where the optical sensor is disposed corresponding to the opening.

In a fifth implementation with reference to the third implementation, the screen assembly further includes a touch layer, a polarizer, and a cover plate. The touch layer, the polarizer, and the cover plate are stacked on the encapsulation layer sequentially. The touch layer and the polarizer are connected by first optical glue. The polarizer and the cover plate are connected by second optical glue.

In another aspect of the disclosure, a display assembly is further provided. The display assembly includes a screen assembly and an optical sensor. The screen assembly has a first surface and a second surface opposite to the first surface. The optical sensor is disposed on one side of the first surface. The screen assembly is configured to emit a first optical signal toward one side of the second surface. The optical sensor is configured to receive a second optical signal and collect a fingerprint image of a target object according to the second optical signal, where the second optical signal is obtained through reflection of the first optical signal by the second surface. The screen assembly includes an adjustment layer. The adjustment layer has a refractive index greater than a preset refractive index, to improve accuracy of the optical sensor in recognizing the fingerprint image, where the preset refractive index is equal to a refractive index of nitrogen.

In a first implementation, the screen assembly further includes an isolation column. The screen assembly further includes a driving circuit and a light-emitting unit. The driving circuit is configured to drive the light-emitting unit to work. The isolation column is disposed corresponding to a storage capacitor in the driving circuit.

In a second implementation with reference to the first implementation, the screen assembly further includes an encapsulation layer. The encapsulation layer and the light-emitting unit cooperatively define a closed cavity. The closed cavity is filled with inert gas. The adjustment layer includes the closed cavity and the inert gas sealed in the closed cavity.

In a third implementation with reference to the second implementation, the screen assembly further includes the encapsulation layer. The light-emitting unit further includes a cathode layer. The encapsulation layer and the cathode layer cooperatively define the closed cavity. A refractive index at which the second optical signal is transmitted in the inert gas is a first refractive index. A refractive index at which the second optical signal is transmitted in the cathode layer is a second refractive index. A refractive index at which the second optical signal is transmitted in the encapsulation layer is a third refractive index. A difference between the second refractive index and the first refractive index is within a first preset difference range. A difference between the third refractive index and the first refractive index is within a second preset difference range.

In a fourth implementation with reference to the first implementation, the adjustment layer is provided with an organic layer. The organic layer is an optically transparent layer. A fourth refractive index at which the second optical signal is transmitted in the organic layer is greater than the preset refractive index.

In a fifth implementation with reference to the first implementation, the screen assembly includes buffer foam and a sealing member. The buffer foam defines an opening, where the optical sensor is disposed corresponding to the opening. The sealing member is annular and is disposed between the buffer foam and the optical sensor. The buffer foam, the optical sensor, and the sealing member cooperatively define a closed space. A light-transmitting portion is received in the closed space. A fifth refractive index at which the second optical signal is transmitted in the light-transmitting portion is greater than the preset refractive index.

In a sixth implementation with reference to the first implementation, the screen assembly includes buffer foam and a sealing member. The buffer foam defines an opening, where the optical sensor is disposed corresponding to the opening. The sealing member is annular and is disposed between the buffer foam and the optical sensor. A reflective coating is provided on an inner wall of the sealing member, and the reflective coating is configured to reflect the second optical signal to the optical sensor.

In yet another aspect of the disclosure, an electronic device is provided. The electronic device includes a display assembly. The display assembly includes an optical sensor and a screen assembly which are stacked. The screen assembly has a display area corresponding to the optical sensor. The screen assembly is configured to emit a first optical signal toward one side away from the optical sensor. The optical sensor is configured to collect a fingerprint image of a target object according to a second optical signal obtained through reflection of the first optical signal. Components in the screen assembly, with light transmittance smaller than preset light transmittance, are at least partially stacked; or, the screen assembly further includes an adjustment layer, the adjustment layer has a refractive index greater than a preset refractive index, to improve accuracy of the optical sensor in recognizing the fingerprint image, where the preset refractive index is equal to a refractive index of nitrogen.

In a first implementation, the screen assembly includes a substrate, a thin-film transistor layer, and a light-emitting unit which are stacked. The substrate is disposed adjacent to the optical sensor. The thin-film transistor layer includes a first metal layer and a second metal layer which are insulated from each other. The light-emitting unit includes a third metal layer. At least two projections of the first metal layer, the second metal layer, and the third metal layer on the substrate are partially overlapped.

In a second implementation, the screen assembly further includes an isolation column. The screen assembly further includes a driving circuit and a light-emitting unit. The driving circuit is configured to drive the light-emitting unit to work. The isolation column is disposed corresponding to a storage capacitor in the driving circuit.

In a third implementation, the adjustment layer is provided with an organic layer. The organic layer is an optically transparent layer. A fourth refractive index at which the second optical signal is transmitted in the organic layer is greater than the preset refractive index.

In a fourth implementation, the screen assembly includes buffer foam and a sealing member. The buffer foam defines an opening, where the optical sensor is disposed corresponding to the opening. The sealing member is annular and is disposed between the buffer foam and the optical sensor. The buffer foam, the optical sensor, and the sealing member cooperatively define a closed space. A light-transmitting portion is received in the closed space. A fifth refractive index at which the second optical signal is transmitted in the light-transmitting portion is greater than the preset refractive index.

In a fifth implementation, the screen assembly includes buffer foam and a sealing member. The buffer foam defines an opening, where the optical sensor is disposed corresponding to the opening. The sealing member is annular and is disposed between the buffer foam and the optical sensor. A reflective coating is provided on an inner wall of the sealing member, and the reflective coating is configured to reflect the second optical signal to the optical sensor.

In a sixth implementation, the electronic device further includes a main circuit board, a frame, and a rear cover. The optical sensor is electrically connected to the main circuit board through a flexible circuit board. The main circuit board, the optical sensor, and the display assembly are fixed to the frame. The rear cover is covered on the frame.

Hereinafter, technical solutions embodied by implementations of the disclosure will be described in a clear and comprehensive manner with reference to accompanying drawings intended for the implementations. It is evident that the implementations described herein constitute merely some rather than all implementations of the disclosure, and that those of ordinary skill in the art will be able to derive other implementations based on these implementations without making creative efforts, and all such derived implementations shall fall within the protection scope of the disclosure.

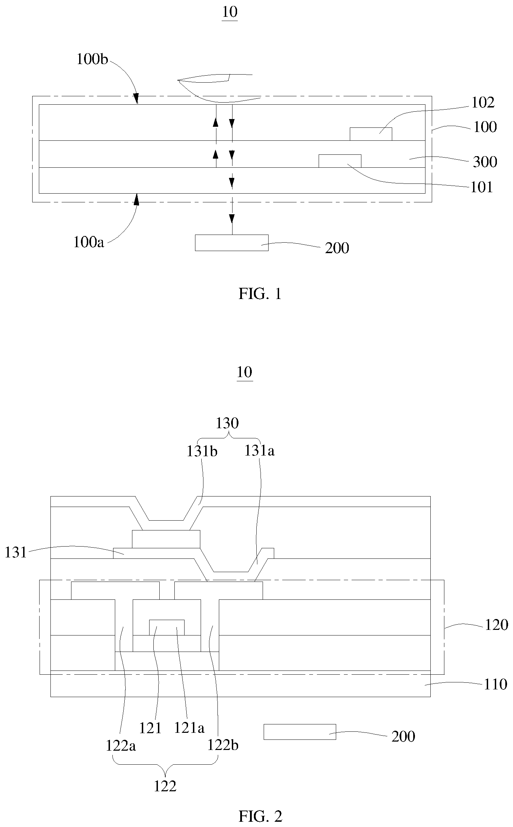

FIG. 1 is a schematic structural diagram illustrating a display assembly according to a first implementation. In the implementation, a display assembly 10 includes a screen assembly 100 and an optical sensor 200 which are stacked. The screen assembly 100 is configured to emit a first optical signal toward one side away from the optical sensor 200. The optical sensor 200 is configured to collect a fingerprint image of a target object according to a second optical signal obtained through reflection of the first optical signal. Components in the screen assembly 100 with light transmittance smaller than preset light transmittance are at least partially stacked, to improve accuracy of the optical sensor 200 in recognizing the fingerprint image. Alternatively, the screen assembly 100 further includes an adjustment layer 300, and the adjustment layer 300 has a refractive index greater than a preset refractive index, to improve accuracy of the optical sensor 200 in recognizing the fingerprint image, where the preset refractive index is equal to a refractive index of nitrogen.

The screen assembly 100 may be a flexible display screen. The optical sensor 200 generally refers to a device that can sense light energy of ultraviolet light to infrared light and convert the light energy into an electrical signal. An optical signal recognized by the optical sensor 200 may be visible light or invisible light.

The optical signal for example is visible light, and a photoelectric effect occurs when a photosensitive layer of the optical sensor 200 senses the visible light. As an example, the photosensitive layer of the optical sensor 200 is made of a silicon-rich compound. The silicon-rich compound includes, but is not limited to, silicon-rich silicon oxide (SiOx), silicon-rich silicon nitride (SiNy), silicon-rich silicon oxynitride (SiOxNy), etc., where x and *y* are positive integers, for example, x=2 and *y*=2. The optical sensor 200 has an input end made of a transparent conducting material. The transparent conducting material herein may be, but is not limited to, indium tin oxide (ITO). The optical signal passes through the input end of the optical sensor 200 and reaches the photosensitive layer of the optical sensor 200.

If the screen assembly 100 is a flexible display screen, the screen assembly 100 has a self-luminous characteristic. The screen assembly 100 is configured to emit a first optical signal toward one side away from the optical sensor 200. After the first optical signal reaches a user's finger pressed on an outer surface of the screen assembly 100, part of the first optical signal is lost due to diffuse reflection on the finger, and the rest (i.e., a second optical signal, that is, reflected first optical signal) carries fingerprint information of the finger. The second optical signal reaches the optical sensor 200 after passing through the screen assembly 100. Then the second optical signal is received by the optical sensor 200 and converted into a fingerprint image. When the second optical signal passes through the screen assembly 100, due to low light transmittance of a component(s) in the screen assembly 100, arrangement of the component(s) in the screen assembly 100 will block the second optical signal, which causes loss of the second optical signal when passing through the screen assembly 100. In addition, since each layer structure of the screen assembly 100 may have a different refractive index, different degrees of refraction may occur to the second optical signal when the second optical signal passes through each layer structure of the screen assembly 100. As a result, a transmission path of the second optical signal becomes longer, which in turn causes loss of the second optical signal.

In view of the above deficiencies, in order to reduce loss of the second optical signal and avoid affecting resolution of a fingerprint image collected by an optical fingerprint sensor, in the disclosure, on the one hand, arrangement of the components in the screen assembly 100 is optimized. As an example, the screen assembly 100 includes a first component 101 and a second component 102, and the first component 101 and the second component 102 each have light transmittance smaller than the preset light transmittance, that is, the first component 101 and the second component 102 each have relatively small light transmittance. In this case, the first component 101 and the second component 102 are arranged to be at least partially stacked, that is, components with relatively small light transmittance are at least partially stacked. In this way, an area blocking the second optical signal is reduced, so that more second optical signal can be transmitted to the optical sensor 200, which is beneficial to improving resolution of the fingerprint image collected by the optical sensor 200, thereby improving accuracy of recognition of optical fingerprint. On the other hand, the screen assembly 100 is provided with an adjustment layer 300, and the adjustment layer 300 has a refractive index greater than a refractive index of nitrogen. Generally, the adjustment layer 300 is filled with nitrogen to prevent the components in the screen assembly 100 from being corroded by moisture or oxygen and affecting the service life. If the refractive index of the adjustment layer 300 is greater than that of nitrogen, refractive indexes of various layer structures in the screen assembly 100 are relatively close, that is, differences between the refractive indexes of the layer structures are smaller than a threshold. In this way, a transmission path of the second optical signal in the screen assembly 100 can be shortened, so that the second optical signal can be transmitted in an approximately straight line, which can optimize the transmission path of the second optical signal, thereby reducing loss of the second optical signal and improving accuracy of recognition of optical fingerprint.

The terms "first", "second", and so on are merely used to distinguish different objects, and these terms are neither intended to limit the number of the objects nor the order of the objects.

The screen assembly 100 has a first surface 100a and a second surface 100b opposite to each other. The optical sensor 200 is disposed on one side of the first surface 100a. The screen assembly 100 is configured to emit a first optical signal toward one side of the second surface 100b. The optical sensor 200 is configured to receive a second optical signal and collect a fingerprint image of a target object according to the second optical signal, where the second optical signal is obtained through reflection of the first optical signal by the second surface 100b.

In implementations of the disclosure, the display assembly 10 includes the optical sensor 200 and the screen assembly 100 which are stacked. The screen assembly 100 is configured to emit an optical signal. The optical sensor 200 is configured to receive the optical signal to collect the fingerprint image of the target object. Components in the screen assembly 100 with light transmittance smaller than the preset light transmittance are arranged to be at least partially stacked, to reduce blocking of the optical signal. As such, the amount of the optical signal received by the optical sensor 200 can be increased, thereby improving accuracy of fingerprint recognition. Alternatively, a refractive index of an adjustment layer 300 in the screen assembly 100 is adjusted, so that the refractive index of the adjustment layer 300 is greater than the preset refractive index, where the preset refractive index is a refractive index of nitrogen. As such, a transmission path of the optical signal can be shortened and loss of the optical signal can be reduced, thereby improving accuracy of fingerprint recognition.

FIG. 2 is a schematic structural diagram illustrating a display assembly according to a second implementation. The display assembly described in the second implementation is basically the same in structure as the display assembly described in the first implementation except the following differences. The screen assembly 100 includes a substrate 110, a thin-film transistor layer 120, and a light-emitting unit 130 which are stacked. The substrate 110 is disposed adjacent to the optical sensor 200. The thin-film transistor layer 120 includes a first metal layer 121 and a second metal layer 122 which are insulated from each other. The light-emitting unit 130 includes a third metal layer 131. At least two projections of the first metal layer 121, the second metal layer 122, and the third metal layer 131 on the substrate 110 are partially overlapped.

The substrate 110 may be a rigid substrate 110, such as a glass substrate 110. The substrate 110 may also be a flexible substrate 110. As an example, the flexible substrate 110 includes polyimide film (PI) and copper foil or includes polyester film and copper foil. Polyimide has excellent properties, such as high temperature soldering resistance, high strength, flame retardancy, etc. Polyimide, as a polymer material, has outstanding thermal stability, good radiation resistance, good chemical stability, and excellent mechanical properties.

Specifically, the first metal layer 121 includes a gate 121a and a gate line electrically connected to the gate 121a. The second metal layer 122 includes a source 122a and a drain 122b. The third metal layer 131 includes an anode layer 131a, a first transmission line, and a second transmission line. The first transmission line is configured to transmit a first signal, and the second transmission line is configured to transmit a second signal. The first signal is loaded on the anode layer 131a of the light-emitting unit 130 and the second signal is loaded on a cathode layer 131b of the light-emitting unit 130, to drive the light-emitting unit 130 to emit lights. The first signal may be a high-level signal or a low-level signal. The second signal may be a high-level signal or a low-level signal. There is a potential difference between the first signal and the second signal.

At least two of a projection of the first metal layer 121 on the substrate 110, a projection of the second metal layer 122 on the substrate 110, and a projection of the third metal layer 131 on the substrate 110 are partially overlapped. In an implementation, the projection of the first metal layer 121 on the substrate 110 and the projection of the second metal layer 122 on the substrate 110 are at least partially overlapped. On condition that the projections of the first metal layer 121 and the second metal layer 122 on the substrate 110 are partially overlapped, blocking of the second optical signal can be reduced. As such, more second optical signal can be transmitted to the optical sensor 200, thereby improving accuracy of fingerprint recognition. In another implementation, the projection of the first metal layer 121 on the substrate 110 and the projection of the third metal layer 131 on the substrate 110 are at least partially overlapped. On condition that the projections of the first metal layer 121 and the third metal layer 131 on the substrate 110 are partially overlapped, blocking of the second optical signal can be reduced. As such, more second optical signal can be transmitted to the optical sensor 200, thereby improving accuracy of fingerprint recognition. In yet another implementation, the projection of the second metal layer 122 on the substrate 110 and the projection of the third metal layer 131 on the substrate 110 are at least partially overlapped. On condition that the projections of the second metal layer 122 and the third metal layer 131 on the substrate 110 are partially overlapped, blocking of the second optical signal can be reduced. As such, more second optical signal can be transmitted to the optical sensor 200, thereby improving accuracy of fingerprint recognition. In yet still another implementation, the projection of the first metal layer 121 on the substrate 110, the projection of the second metal layer 122 on the substrate 110, and the projection of the third metal layer 131 on the substrate 110 are at least partially overlapped. On condition that the projections of the first metal layer 121, the second metal layer 122, and the third metal layer 131 on the substrate 110 are partially overlapped, blocking of the second optical signal can be reduced. As such, more second optical signal can be transmitted to the optical sensor 200, thereby improving accuracy of fingerprint recognition.

It is understood that, areas of the first metal layer 121, the second metal layer 122, and the third metal layer 131 are reduced, that is, a relatively thin gate line, a relatively thin first transmission line, and a relatively thin second transmission line are provided, so that the size of the gate line, the size of the first transmission line, and the size of the second transmission line are smaller than a preset size, which can reduce blocking of the second optical signal caused by the gate line, the first transmission line, and the second transmission line. As such, more second optical signal can be transmitted to the optical sensor 200, thereby improving resolution of the fingerprint image collected by the optical sensor 200 and accuracy of recognition of optical fingerprint.

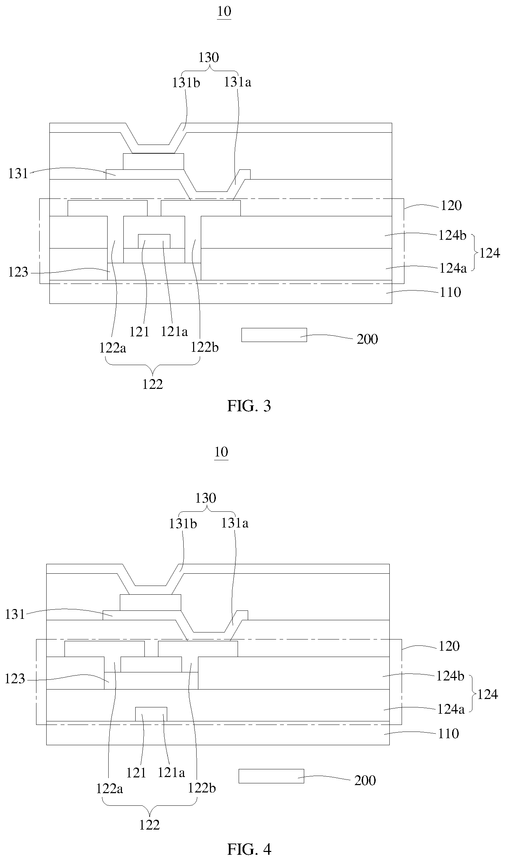

FIG. 3 is a schematic structural diagram illustrating a display assembly according to a third implementation. The display assembly described in the third implementation is basically the same in structure as the display assembly described in the second implementation except the following differences. The first metal layer 121 includes a gate 121a. The thin-film transistor layer 120 further includes an active layer 123 and an insulating layer 124. The active layer 123, the insulating layer 124, and the gate 121a are stacked sequentially, and the active layer 123 is disposed adjacent to the substrate 110.

Specifically, the thin-film transistor layer 120 further includes a source 122a and a drain 122b. The active layer 123 is disposed on the substrate 110. The insulating layer 124 includes a first sub-insulating layer 124a and a second sub-insulating layer 124b. The first sub-insulating layer 124a covers the active layer 123. The gate 121a is disposed on the first sub-insulating layer 124a, and the gate 121a is disposed corresponding to the active layer 123. The second sub-insulating layer 124b covers the gate 121a. Both the source 122a and the drain 122b are disposed on the second sub-insulating layer 124b. The source 122a is spaced apart from the drain 122b. The source 122a is electrically connected to one end of the active layer 123 through a hole extending through the first sub-insulating layer 124a and the second sub-insulating layer 124b. The drain 122b is electrically connected to the other end of the active layer 123 through a hole extending through the first sub-insulating layer 124a and the second sub-insulating layer 124b.

The anode layer 131a is disposed on a surface of the drain 122b. The anode layer 131a is electrically connected with the drain 122b. The anode layer 131a can be electrically connected with the drain 122b through direct surface bonding, bridge connection, or the like.

FIG. 4 is a schematic structural diagram illustrating a display assembly according to a fourth implementation. The display assembly described in the fourth implementation is basically the same in structure as the display assembly described in the second implementation except the following differences. The first metal layer 121 includes the gate 121a. The thin-film transistor layer 120 further includes the active layer 123 and the insulating layer 124. The gate 121a, the insulating layer 124, and the active layer 123 are stacked sequentially, and the gate 121a is disposed adjacent to the substrate 110.

Specifically, the thin-film transistor layer 120 further includes the source 122a and the drain 122b. The source 122a and the drain 122b are disposed on a surface of the insulating layer 124. The source 122a is electrically connected with one end of the active layer 123. The drain 122b is electrically connected with the other end of the active layer 123. The source 122a is electrically connected with the drain 122b through the active layer 123. The anode layer 131a is disposed on a surface of the drain 122b. The anode layer 131a is electrically connected with the drain 122b.

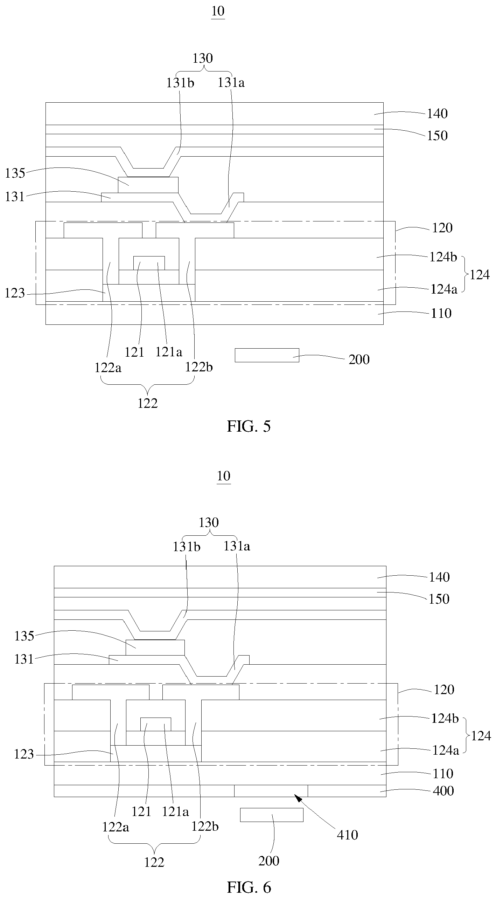

FIG. 5 is a schematic structural diagram illustrating a display assembly according to a fifth implementation. The display assembly described in the fifth implementation is basically the same in structure as the display assembly described in the second implementation except the following differences. The screen assembly 100 further includes an encapsulation layer 140. The light-emitting unit 130 further includes a light-emitting layer 135 and a cathode layer 131b. The third metal layer 131 includes the anode layer 131a. The light-emitting layer 135 is sandwiched between the anode layer 131a and the cathode layer 131b. The screen assembly 100 further includes a protective layer 150 disposed between the cathode layer 131b and the encapsulation layer 140. The protective layer 150 is configured to provide an anti-oxidation protection for the light-emitting layer 135.

The light-emitting layer 135 may be an organic light-emitting layer 135. The protective layer 150 may be a desiccant. The protective layer 150 is used to prevent the cathode layer 131b, the light-emitting layer 135, and functional components below the light-emitting layer 135 from being corroded by moisture.

The encapsulation layer 140 is a transparent layer and generally adopts thin-film encapsulation, to provide protection for the cathode layer 131b. In order to avoid degradation of electrical performances caused by corrosion of impurities in the air to the cathode layer 131b and layers below the cathode layer 131b, the cathode layer 131b and the layers below the cathode layer 131b should be isolated from the outside. The encapsulation layer 140 can protect surfaces of the cathode layer 131b and the layers below the cathode layer 131b, the gate line, the first transmission line, and the second transmission line, so as to prevent the cathode layer 131b and the layers below the cathode layer 131b from being damaged by an external force and from being affected by an external environment in terms of electrical or thermal physics, etc. Moreover, after encapsulation, thermal expansion coefficients (i.e., the coefficient of thermal expansion) of the cathode layer 131b and the layers below the cathode layer 131b are matched with a thermal expansion coefficient of a frame or the substrate 110, which can relieve a stress caused by changes in the external environment (e.g., heat) and a stress caused by heat generated by a chip. As such, the cathode layer 131b and the layers below the cathode layer 131b can be prevented from damage and failure. Based on heat dissipation considerations, the encapsulation layer should be as thin as possible. On the other hand, encapsulation of the cathode layer 131b and the layers below the cathode layer 131b is beneficial to installation and transportation.

The protective layer 150 is disposed on a surface of the encapsulation layer 140 adjacent to the cathode layer 131b. Generally, the encapsulation layer 140 and the cathode layer 131b cooperatively define a cavity, so that inert gas can be filled in the cavity. The inert gas is to avoid shortening of service life of the screen assembly 100 caused by corrosion of moisture or oxygen to components in the screen assembly 100.

FIG. 6 is a schematic structural diagram illustrating a display assembly according to a sixth implementation. The display assembly described in the sixth implementation is basically the same in structure as the display assembly described in the second implementation except the following differences. The screen assembly 100 further includes buffer foam 400. The buffer foam 400 is disposed between the optical sensor 200 and the substrate 110. The buffer foam 400 defines an opening 410, and the optical sensor 200 is disposed corresponding to the opening 410.

Specifically, the buffer foam 400 is fixed on a surface of the substrate 110 adjacent to the optical sensor 200. The buffer foam 400 is disposed between the substrate 110 and the optical sensor 200, which can provide buffer protection for the substrate 110 and the optical sensor 200. The buffer foam 400 defines the opening 410, where the opening 410 extends through the buffer foam 400. The optical sensor 200 is disposed corresponding to the opening 410. The second optical signal can reach the optical sensor 200 after passing through the opening 410, and then the second optical signal is received by the optical sensor 200.

The opening 410 may be in a shape of circular, rectangular, or other shapes. In an implementation, a radial size of the opening 410 is larger than a radial size of a lens of the optical sensor 200. The optical sensor 200 is spaced apart from the substrate 110 by 1-2 millimeters (mm), and the second optical signal, which is transmitted to the optical sensor 200, is in a tapered pattern. If the radial size of the opening 410 is the same as that of the lens of the optical sensor 200, part of a side wall of the opening 410 defined in the buffer foam 400 will block part of the second optical signal, which causes unnecessary loss of the second optical signal. Therefore, in view of the above deficiencies, the opening 410 has a radial size larger than that of the lens of the optical sensor 200. As such, more second optical signal can be transmitted to the optical sensor 200, thereby improving resolution of a fingerprint image obtained by the optical sensor 200 and accuracy of recognition of optical fingerprint.

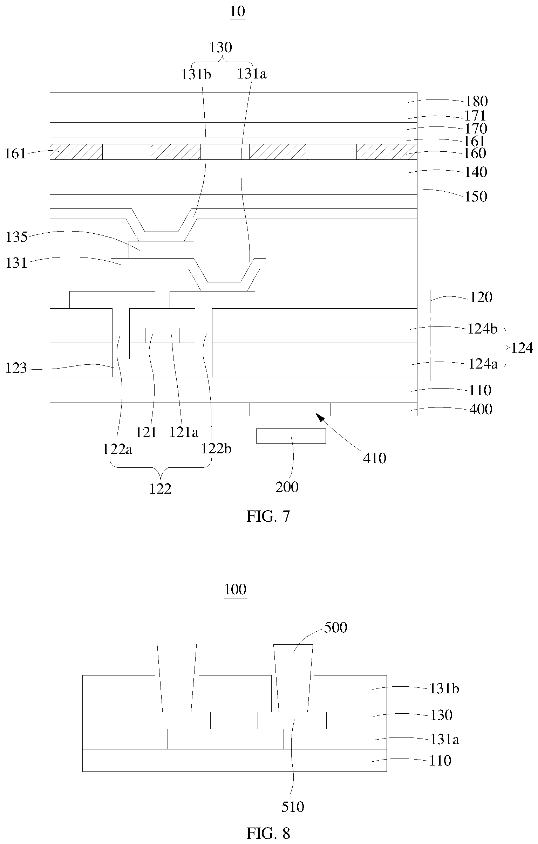

FIG. 7 is a schematic structural diagram illustrating a display assembly according to a seventh implementation. The display assembly described in the seventh implementation is basically the same in structure as the display assembly described in the fifth implementation except the following differences. The screen assembly 100 further includes a touch layer 160, a polarizer 170, and a cover plate 180. The touch layer 160, the polarizer 170, and the cover plate 180 are stacked on the encapsulation layer 140 sequentially. The touch layer 160 and the polarizer 170 are connected by first optical glue 161. The polarizer 170 and the cover plate 180 are connected by second optical glue 171.

The touch layer 160 is configured to sense a touch action, convert the touch action into a touch signal, and transmit the touch signal to a controller to generate a control instruction, so as to implement a corresponding touch function.

In an implementation, the screen assembly 100 has a well-encapsulated integrated structure, and the touch layer 160 and the screen assembly 100 are stacked. That is, the touch layer 160 may be disposed above the screen assembly 100 or below the screen assembly 100. If the touch layer 160 is disposed above the screen assembly 100, the touch layer 160 can serve as the encapsulation layer 140. In this case, the touch layer 160 can protect the screen assembly 100 on the one hand, and can be used to detect a touch action on the screen assembly 100 applied from the outside of the screen assembly 100, and to generate a touch signal according to the touch action on the other hand. Since the touch layer 160 is disposed above the screen assembly 100, a touch action can directly act on the touch layer 160 when acting on the screen assembly 100, that is, the touch action can be applied to the touch layer 160 directly without via other intermediate layer structures. In this case, the touch layer 160 is more sensitive to the touch action, which can reduce the thickness of the touch layer 160 while ensuring high detection accuracy of the touch layer 160, thereby promoting realization of a thin and light design of the display assembly 10.

In other implementations, the touch layer 160 is embedded in the screen assembly 100. That is, the touch layer 160 is disposed between any two adjacent layers of the screen assembly 100. If the touch layer 160 is embedded in the screen assembly 100, the touch layer 160 and the screen assembly 100 can be integrated as a whole, which can promote realization of a modular design and facilitate subsequent installation, disassembly, and replacement. Moreover, since the touch layer 160 is embedded in the screen assembly 100, the touch layer 160 can be well attached to the screen assembly 100. Furthermore, the touch layer 160 is attached to the screen assembly 100, which can effectively prevent the touch layer 160 from falling off the screen assembly 100, thereby prolonging service life of the display assembly 10.

In other implementations, the touch layer 160 has an integral layer structure, and has a same size as the screen assembly 100, so that a touch action occurring at any location of the screen assembly 100 can be detected, which can improve accuracy of touch detection.

In other implementations, the touch layer 160 includes multiple small sensing units 161 arranged at intervals. In this case, since adjacent sensing units 161 are arranged at intervals, there will be no mutual squeezing between the adjacent sensing units 161, which can eliminate a stress between the adjacent sensing units 161, thereby releasing a stress between the touch layer 160 and the screen assembly 100. As such, stress concentration can be avoided. If stress concentration between the screen assembly 100 and the touch layer 160 exists, an internal stress between the screen assembly 100 and the touch layer 160 may interfere with an external pressure, which can lead to inaccuracy of touch detection. Therefore, multiple sensing units 161 are arranged at intervals to form the touch layer 160. As such, the stress concentration between the screen assembly 100 and the touch layer 160 can be solved, thereby improving detection accuracy of the display assembly 10 in detecting a touch action, and improving touch sensitivity of the display assembly 10.

Optionally, multiple sensing units 161 are arranged in an array to form the touch layer 160. If a touch action is applied to a sensing unit 161, the sensing unit 161 detects the touch action which is applied on the screen assembly 100 from the outside of the screen assembly 100, and indicates a location and a trajectory of the touch action on the screen assembly 100. If a touch action is applied to a location between two adjacent sensing units 161, touch locations corresponding to the touch action and detected by the two adjacent sensing units 161 are averaged to detect the touch action, and a location and a trajectory of the touch action on the screen assembly 100 are indicated. If a touch action is applied to multiple adjacent sensing units 161 at the same time, weights (or percentages) are assigned to each of the sensing units 161 according to a distance between a center of each of the sensing units 161 and a touch location corresponding to the touch action and detected by the corresponding sensing unit 161, and a location of the touch action on the screen assembly 100 is calculated according to the weights assigned to each of the multiple sensing units 161. The location and a trajectory of the touch action on the screen assembly 100 are indicated. Moreover, the shorter a distance between a center of a sensing unit 161 and a touch location corresponding to the touch action and detected by the sensing unit 161, the larger a weight is assigned to the sensing unit 161.

For example, the touch action is applied to a first sensing unit, a second sensing unit, and a third sensing unit which are adjacent at the same time, a distance between the first sensing unit and a touch location corresponding to the touch action and detected by the first sensing unit is denoted as *d1,* a distance between the second sensing unit and a touch location corresponding to the touch action and detected by the second sensing unit is denoted as *d2,* and a distance between the third sensing unit and a touch location corresponding to the touch action and detected by the third sensing unit is denoted as *d3.* Weight *a1* is assigned to the first sensing unit, weight *a2* is assigned to the second sensing unit, and weight *a3* is assigned to the third sensing unit, to calculate a location of the touch action. If *d1<d2<d3,* then *a1>a2>a3,* and *a1+a2+a3*=1*.*

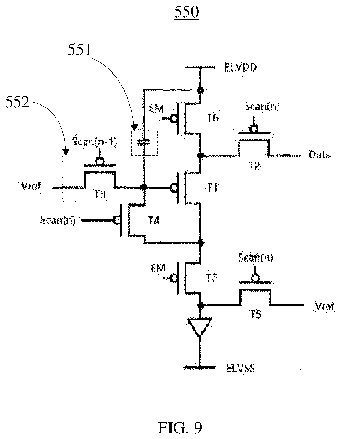

FIG. 8 is a schematic structural diagram illustrating a display assembly according to an eighth implementation. FIG. 9 is a schematic diagram illustrating a driving circuit of a light-emitting unit of a display assembly in the disclosure. The display assembly described in the eighth implementation is basically the same in structure as the display assembly described in the first implementation except the following differences. The screen assembly 100 further includes an isolation column 500. The screen assembly 100 further includes a driving circuit 550 and a light-emitting unit 130. The driving circuit 550 is configured to drive the light-emitting unit 130 to work. The isolation column 500 is disposed corresponding to a storage capacitor 551 in the driving circuit 550.

The driving circuit 550 includes the storage capacitor 551 and a switch unit 552. The storage capacitor 551 and the switch unit 552 cooperate with each other to drive the light-emitting unit 130 to work.

The isolation column 500 can prevent prepared films of the screen assembly 100 and a photomask from being scratched when a photomask-based vapor deposition is performed on a light-emitting layer 135 of the screen assembly 100. Although the isolation column 500 is made of material with relatively high light transmittance, the isolation column 500 can still cause loss of lights. Therefore, the isolation column 500 should be disposed in an area with relatively low light transmittance. As such, loss of the light transmittance can be minimized. Considering that the storage capacitor 551 in the driving circuit 550 has relatively low light transmittance, in the implementation, the isolation column 500 is disposed corresponding to the storage capacitor 551, to reduce undesirable interference of the isolation column 500 and the storage capacitor 551 to the light transmittance. If the isolation column 500 is disposed corresponding to the storage capacitor 551, the overall light transmittance can be increased by about 0.91%.

In an implementation, the isolation column 500 is disposed corresponding to the storage capacitor 551, and the isolation column 500 and the storage capacitor 551 are disposed to avoid the light-emitting unit 130. Adjacent light-emitting units 130 are separated by an isolation layer 510, to avoid color collision of lights emitted by the adjacent light-emitting units 130. The isolation column 500 and the storage capacitor 551 are disposed corresponding to the isolation layer 510, to avoid the light-emitting unit 130. As such, on the one hand, the isolation column 500 can avoid the prepared light-emitting unit 130 from being damaged during preparation of the light-emitting unit 130. On the other hand, the isolation column 500 and the storage capacitor 551 are disposed to avoid the light-emitting unit 130, which can reduce blocking of the light-emitting unit 130 caused by the isolation column 500 and the storage capacitor 551, thereby avoiding poor display of the display assembly 10.

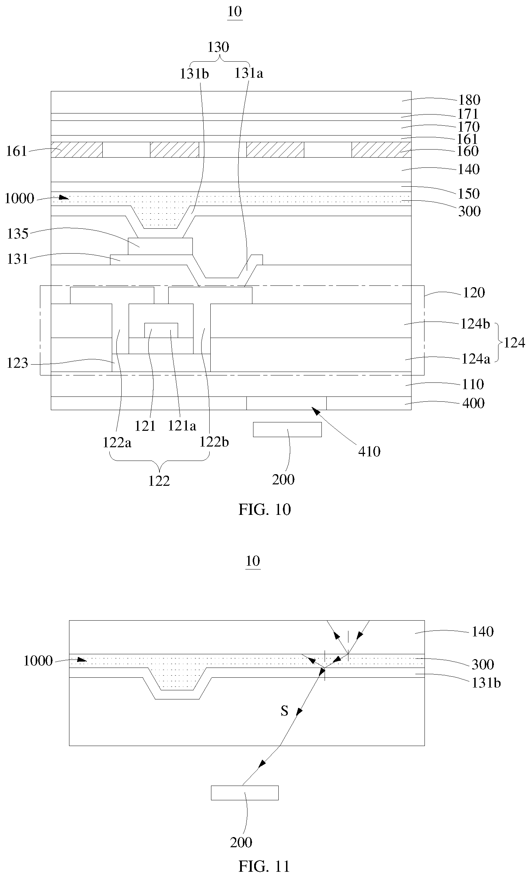

FIG. 10 is a schematic structural diagram illustrating a display assembly according to a ninth implementation. The display assembly described in the ninth implementation is basically the same in structure as the display assembly described in the eighth implementation except the following differences. The screen assembly 100 further includes an encapsulation layer 140. The encapsulation layer 140 and the light-emitting unit 130 cooperatively define a closed cavity 1000. The closed cavity 1000 is filled with inert gas. The adjustment layer 300 includes the closed cavity 1000 and the inert gas sealed in the closed cavity 1000.

In the related art, the closed cavity 1000 defined between the encapsulation layer 140 and the light-emitting unit 130 is filled with nitrogen, to prevent components in the screen assembly 100 from being corroded by moisture or oxygen and affecting their service life. In the disclosure, the closed cavity 1000 defined between the encapsulation layer 140 and the light-emitting unit 130 is filled with inert gas, to reduce the differences between refractive indexes of layer structures of the screen assembly 100, so that lights are transmitted in an approximately straight line within the screen assembly 100. In this way, a transmission path of the lights can be shortened, thereby reducing loss of the lights. Accordingly, more second optical signal can be transmitted to the optical sensor 200, so as to improve resolution of the fingerprint image collected by the optical sensor 200 and accuracy of fingerprint recognition.

The adjustment layer 300 may have an integral encapsulation structure, including the closed cavity 1000 and the inert gas sealed in the closed cavity 1000, which can simplify a manufacturing process of the display assembly 10.

FIG. 11 is a schematic structural diagram illustrating a display assembly according to a tenth implementation. The display assembly described in the tenth implementation is basically the same in structure as the display assembly described in the ninth implementation except the following differences. The screen assembly 100 further includes the encapsulation layer 140. The light-emitting unit 130 further includes a cathode layer 131b. The encapsulation layer 140 and the cathode layer 131b cooperatively define the closed cavity 1000. A refractive index at which the second optical signal is transmitted in the inert gas is a first refractive index. A refractive index at which the second optical signal is transmitted in the cathode layer 131b is a second refractive index. A refractive index at which the second optical signal is transmitted in the encapsulation layer 140 is a third refractive index. A difference between the second refractive index and the first refractive index is within a first preset difference range. A difference between the third refractive index and the first refractive index is within a second preset difference range.

Specifically, the encapsulation layer 140 and the cathode layer 131b cooperatively define the closed cavity 1000, and the closed cavity 1000 is filled with inert gas. If the difference between the second refractive index and the first refractive index is within the first preset difference range and the difference between the third refractive index and the first refractive index is within the second preset difference range, differences among the first refractive index, the second refractive index, and the third refractive index are relatively small, and accordingly, a refraction effect of lights is relatively weak. As such, the second optical signal can be transmitted approximately in a straight line within the screen assembly 100, therefore, a transmission path of the second optical signal can be shortened, loss of the second optical signal can be reduced, and more second optical signal can be transmitted to the optical sensor 200, thereby improving resolution of the fingerprint image collected by the optical sensor 200 and accuracy of recognition of optical fingerprint.

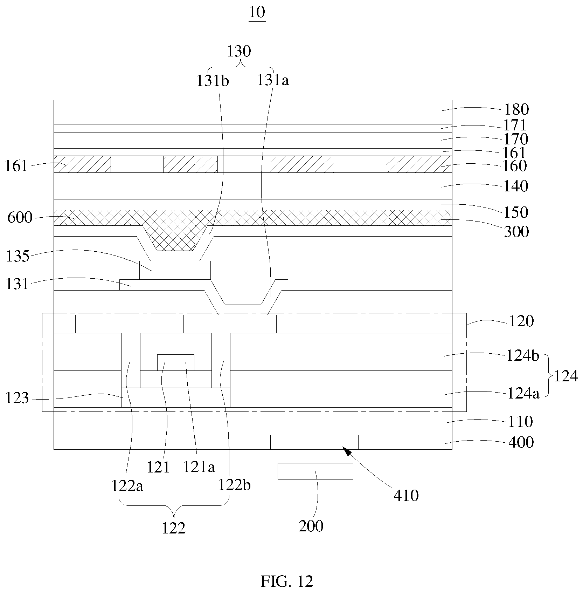

FIG. 12 is a schematic structural diagram illustrating a display assembly according to an eleventh implementation. The display assembly described in the eleventh implementation is basically the same in structure as the display assembly described in the first implementation except the following differences. The adjustment layer 300 is provided with an organic layer 600. The organic layer 600 is an optically transparent layer. A fourth refractive index at which the second optical signal is transmitted in the organic layer 600 is greater than a preset refractive index, where the preset refractive index is a refractive index at which the second optical signal is transmitted in nitrogen.

Specifically, the adjustment layer 300 is provided with the organic layer 600, and the fourth refractive index is greater than the preset refractive index. The refractive index at which the second optical signal is transmitted in the adjustment layer 300 can be increased, to weaken a refraction effect of lights. In this way, a relatively large refraction and deflection angle of the second optical signal can be avoided, and a transmission path of the second optical signal can be shortened, so that the second optical signal can be transmitted in an approximately straight line, which can reduce loss of the second optical signal and make more second optical signal be transmitted to the optical sensor 200, thereby improving resolution of the fingerprint image collected by the optical sensor 200 and accuracy of the display assembly 10 in fingerprint recognition.

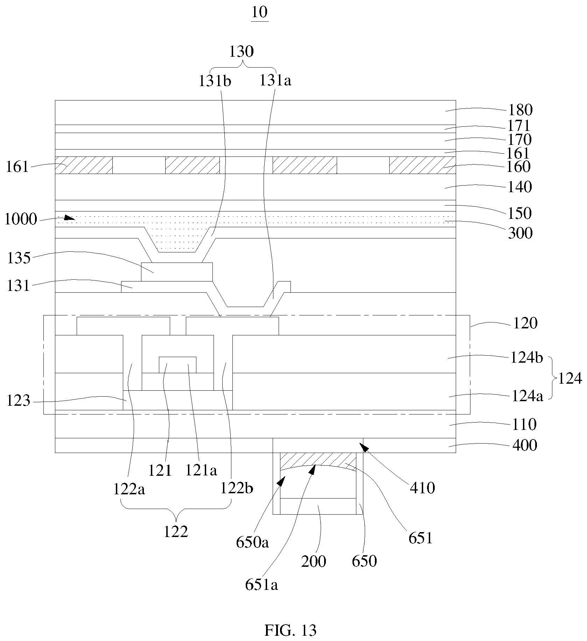

FIG. 13 is a schematic structural diagram illustrating a display assembly according to a twelfth implementation. The display assembly described in the twelfth implementation is basically the same in structure as the display assembly described in the first implementation except the following differences. The screen assembly 100 includes buffer foam 400 and a sealing member 650. The buffer foam 400 defines an opening 410. The optical sensor 200 is disposed corresponding to the opening 410. The sealing member 650 is annular and is disposed between the buffer foam 400 and the optical sensor 200. The buffer foam 400, the optical sensor 200, and the sealing member 650 cooperatively define a closed space 650a. A light-transmitting portion 651 is received in the closed space 650a. A fifth refractive index at which the second optical signal is transmitted in the light-transmitting portion 651 is greater than a preset refractive index, where the preset refractive index is a refractive index at which the second optical signal is transmitted in nitrogen.

Specifically, the fifth refractive index at which the second optical signal is transmitted in the light-transmitting portion 651 is greater than the refractive index at which the second optical signal is transmitted in nitrogen, which can prevent the second optical signal from having a relatively large deflection angle due to refraction, and allow the second optical signal to be deflected at an angle close to the optical sensor 200. As such, more second optical signal can be transmitted to the optical sensor 200, so that the optical sensor 200 can collect a fingerprint image with relatively high resolution, thereby improving accuracy of recognition of optical fingerprint.

In an implementation, the light-transmitting portion 651 is disposed on a surface of the substrate 110 adjacent to the optical sensor 200. A surface of the light-transmitting portion 651 away from the substrate 110 is recessed toward one side close to the substrate 110 to form a concave surface 651a. The concave surface 651a faces the optical sensor 200 directly. The light-transmitting portion 651 has a concave structure, which is conducive to convergence of the second optical signal, so that the second optical signal can be well converged on the optical sensor 200 to be received by the optical sensor 200, thereby improving resolution of the fingerprint image collected by the optical sensor 200 and accuracy of the display assembly 10 in fingerprint recognition.

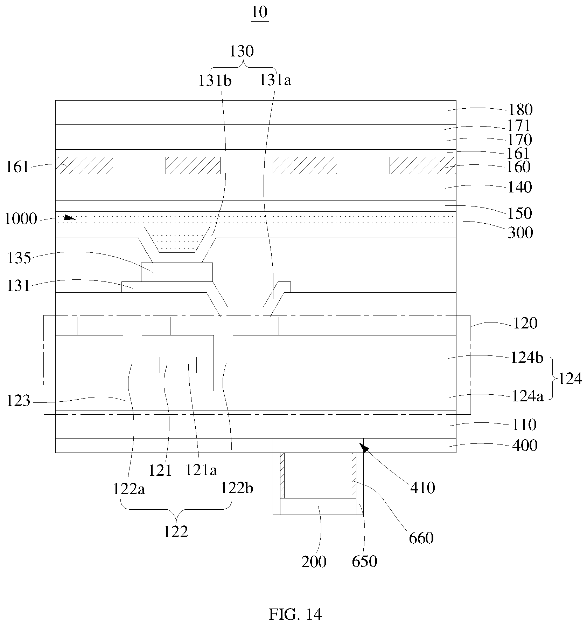

FIG. 14 is a schematic structural diagram illustrating a display assembly according to a thirteenth implementation. The display assembly described in the thirteenth implementation is basically the same in structure as the display assembly described in the first implementation except the following differences. The screen assembly 100 includes buffer foam 400 and a sealing member 650. The buffer foam 400 defines an opening 410. The optical sensor 200 is disposed corresponding to the opening 410. The sealing member 650 is annular and is disposed between the buffer foam 400 and the optical sensor 200. The sealing member 650 is provided with a reflective coating 660 on an inner wall of the sealing member 650, where the reflective coating 660 is configured to reflect the second optical signal to the optical sensor 200.

The reflective coating 660 may be light-shielding ink which can reflect lights.

The reflective coating 660 is provided on the inner wall of the sealing member 650, so that the second optical signal can reach the optical sensor 200 after passing through the screen assembly 100 and being reflected by the reflective coating, and can be received by the optical sensor 200, which can reduce loss of the second optical signal, so that more second optical signal can be transmitted to the optical sensor 200, thereby improving resolution of the fingerprint image collected by the optical sensor 200 and accuracy of the display assembly 10 in fingerprint recognition.

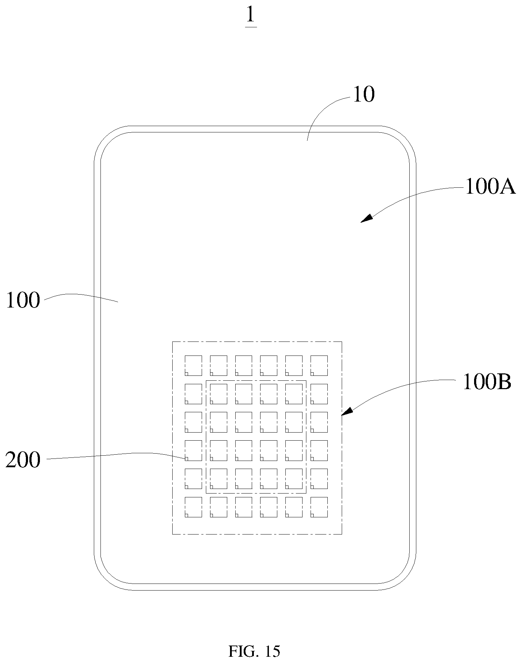

FIG. 15 is a schematic structural diagram illustrating an electronic device according to a first implementation. As illustrated in FIG. 15, an electronic device 1 includes the display assembly 10 described in any of the foregoing implementations. The screen assembly 100 of the display assembly 10 has a display area 100A. The optical sensor 200 is disposed corresponding to the display area 100A.

The electronic device 1 may be any device with communication and storage functions, for example, a tablet computer, a mobile phone, an e-reader, a remote control, a personal computer (PC), a notebook computer, an on-board device, an Internet television (TV), a wearable device, and other smart devices with a network function.

The electronic device 1 further has a fingerprint-recognition area 100B. Multiple optical sensors 200 are arranged in an array in the fingerprint-recognition area 100B.

In an implementation, the screen assembly 100 has the display area 100A, and the optical sensor 200 is disposed corresponding to the display area 100A, which can reduce the size of a non-display area, that is, increasing the size of the display area 100A, so that a screen-tobody ratio can be increased. An optical fingerprint function can be realized by touching the display area 100A of the screen assembly 100.

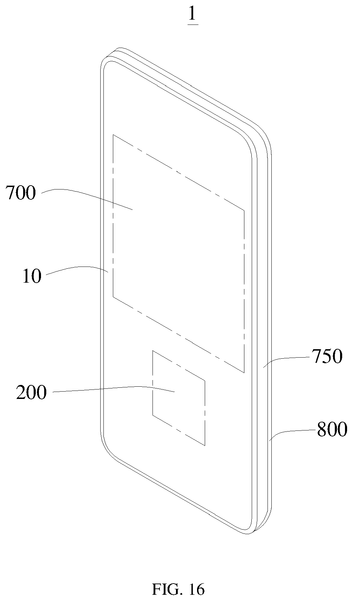

FIG. 16 is a schematic structural diagram illustrating an electronic device according to a second implementation. The electronic device described in the second implementation is basically the same in structure as the electronic device described in the first implementation except the following differences. The electronic device 1 further includes a main circuit board 700, a frame 750, and a rear cover 800. The optical sensor 200 is electrically connected to the main circuit board 700 through a flexible circuit board 850. The main circuit board 700, the optical sensor 200, and the display assembly 10 are all fixed to the frame 750. The rear cover 800 is covered on the frame 750.

The rear cover 800 may be a battery cover.

The optical sensor 200 is configured to convert a second optical signal into a fingerprint image after receiving the second optical signal, and transmit the fingerprint image to the main circuit board 700 through the flexible circuit board 850. The main circuit board 700 is configured to analyze and process the fingerprint image and send out a touch signal, where the touch signal is configured to control the display assembly 10 to realize a touch function corresponding to optical fingerprint.

While the principles and implementations of the disclosure have been described in connection with illustrative implementations, it is to be understood that the foregoing implementations are merely used to help understand the method and the core idea of the disclosure. As will occur to those skilled in the art, the disclosure is susceptible to various modifications and changes without departing from the spirit and principle of the disclosure. Therefore, the disclosure is not to be limited to the disclosed implementations.

## Claims

1. A display assembly, comprising an optical sensor and a screen assembly which are stacked; the screen assembly being configured to emit a first optical signal toward one side away from the optical sensor; the optical sensor being configured to collect a fingerprint image of a target object according to a second optical signal obtained through reflection of the first optical signal; components in the screen assembly, with light transmittance smaller than preset light transmittance, being at least partially stacked, to improve accuracy of the optical sensor in recognizing the fingerprint image.

2. The display assembly of claim 1, wherein the screen assembly comprises a substrate, a thin-film transistor layer, and a light-emitting unit which are stacked; the substrate is disposed adjacent to the optical sensor; the thin-film transistor layer comprises a first metal layer and a second metal layer which are insulated from each other; the light-emitting unit comprises a third metal layer; at least two projections of the first metal layer, the second metal layer, and the third metal layer on the substrate are partially overlapped.

3. The display assembly of claim 2, wherein the first metal layer comprises a gate; the thin-film transistor layer further comprises an active layer and an insulating layer; the active layer, the insulating layer, and the gate are stacked sequentially and the active layer is disposed adjacent to the substrate, or, the gate, the insulating layer, and the active layer are stacked sequentially and the gate is disposed adjacent to the substrate.

4. The display assembly of claim 2, wherein the screen assembly further comprises an encapsulation layer; the light-emitting unit further comprises a light-emitting layer and a cathode layer; the third metal layer comprises an anode layer; the light-emitting layer is sandwiched between the anode layer and the cathode layer; a protective layer is disposed between the cathode layer and the encapsulation layer, and the protective layer is configured to provide an anti-oxidation protection for the light-emitting layer.

5. The display assembly of claim 2 or 3, wherein the screen assembly further comprises buffer foam; the buffer foam is disposed between the optical sensor and the substrate and defines an opening, wherein the optical sensor is disposed corresponding to the opening.

6. The display assembly of claim 4, wherein the screen assembly further comprises a touch layer, a polarizer, and a cover plate; the touch layer, the polarizer, and the cover plate are stacked on the encapsulation layer sequentially; the touch layer and the polarizer are connected by first optical glue, and the polarizer and the cover plate are connected by second optical glue.

7. A display assembly, comprising a screen assembly and an optical sensor; the screen assembly having a first surface and a second surface opposite to the first surface; the optical sensor being disposed on one side of the first surface; the screen assembly being configured to emit a first optical signal toward one side of the second surface; the optical sensor being configured to receive a second optical signal and collect a fingerprint image of a target object according to the second optical signal, the second optical signal being obtained through reflection of the first optical signal by the second surface; the screen assembly comprising an adjustment layer, the adjustment layer having a refractive index greater than a preset refractive index, to improve accuracy of the optical sensor in recognizing the fingerprint image, wherein the preset refractive index is equal to a refractive index of nitrogen.

8. The display assembly of claim 7, wherein the screen assembly further comprises an isolation column; the screen assembly further comprises a driving circuit and a light-emitting unit; the driving circuit is configured to drive the light-emitting unit to work; the isolation column is disposed corresponding to a storage capacitor in the driving circuit.

9. The display assembly of claim 8, wherein the screen assembly further comprises an encapsulation layer; the encapsulation layer and the light-emitting unit cooperatively define a closed cavity, the closed cavity being filled with inert gas; and the adjustment layer comprises the closed cavity and the inert gas sealed in the closed cavity.

10. The display assembly of claim 9, wherein the screen assembly further comprises the encapsulation layer; the light-emitting unit further comprises a cathode layer; the encapsulation layer and the cathode layer cooperatively define the closed cavity; a refractive index at which the second optical signal is transmitted in the inert gas is a first refractive index, a refractive index at which the second optical signal is transmitted in the cathode layer is a second refractive index, a refractive index at which the second optical signal is transmitted in the encapsulation layer is a third refractive index, a difference between the second refractive index and the first refractive index is within a first preset difference range, and a difference between the third refractive index and the first refractive index is within a second preset difference range.

11. The display assembly of claim 7, wherein the adjustment layer is provided with an organic layer; the organic layer is an optically transparent layer, and a fourth refractive index at which the second optical signal is transmitted in the organic layer is greater than the preset refractive index.

12. The display assembly of claim 7, wherein the screen assembly comprises buffer foam and a sealing member; the buffer foam defines an opening, wherein the optical sensor is disposed corresponding to the opening; the sealing member is annular and is disposed between the buffer foam and the optical sensor; the buffer foam, the optical sensor, and the sealing member cooperatively define a closed space; a light-transmitting portion is received in the closed space; a fifth refractive index at which the second optical signal is transmitted in the light-transmitting portion is greater than the preset refractive index.

13. The display assembly of claim 7, wherein the screen assembly comprises buffer foam and a sealing member; the buffer foam defines an opening, wherein the optical sensor is disposed corresponding to the opening; the sealing member is annular and is disposed between the buffer foam and the optical sensor; a reflective coating is provided on an inner wall of the sealing member, and the reflective coating is configured to reflect the second optical signal to the optical sensor.

14. An electronic device, comprising:
a display assembly comprising an optical sensor and a screen assembly which are stacked; the screen assembly having a display area corresponding to the optical sensor; the screen assembly being configured to emit a first optical signal toward one side away from the optical sensor; the optical sensor being configured to collect a fingerprint image of a target object according to a second optical signal obtained through reflection of the first optical signal; components in the screen assembly, with light transmittance smaller than preset light transmittance, being at least partially stacked; or, the screen assembly further comprising an adjustment layer, the adjustment layer having a refractive index greater than a preset refractive index, to improve accuracy of the optical sensor in recognizing the fingerprint image, the preset refractive index being equal to a refractive index of nitrogen.

15. The electronic device of claim 14, wherein the screen assembly comprises a substrate, a thin-film transistor layer, and a light-emitting unit which are stacked; the substrate is disposed adjacent to the optical sensor; the thin-film transistor layer comprises a first metal layer and a second metal layer which are insulated from each other; the light-emitting unit comprises a third metal layer; at least two projections of the first metal layer, the second metal layer, and the third metal layer on the substrate are partially overlapped.

16. The electronic device of claim 14, wherein the screen assembly further comprises an isolation column; the screen assembly further comprises a driving circuit and a light-emitting unit; the driving circuit is configured to drive the light-emitting unit to work; the isolation column is disposed corresponding to a storage capacitor in the driving circuit.

17. The electronic device of claim 14, wherein the adjustment layer is provided with an organic layer; the organic layer is an optically transparent layer, and a fourth refractive index at which the second optical signal is transmitted in the organic layer is greater than the preset refractive index.

18. The electronic device of claim 14, wherein the screen assembly comprises buffer foam and a sealing member; the buffer foam defines an opening, wherein the optical sensor is disposed corresponding to the opening; the sealing member is annular and is disposed between the buffer foam and the optical sensor; the buffer foam, the optical sensor, and the sealing member cooperatively define a closed space; a light-transmitting portion is received in the closed space; a fifth refractive index at which the second optical signal is transmitted in the light-transmitting portion is greater than the preset refractive index.

19. The electronic device of claim 14, wherein the screen assembly comprises buffer foam and a sealing member; the buffer foam defines an opening, wherein the optical sensor is disposed corresponding to the opening; the sealing member is annular and is disposed between the buffer foam and the optical sensor; a reflective coating is provided on an inner wall of the sealing member, and the reflective coating is configured to reflect the second optical signal to the optical sensor.

20. The electronic device of claim 14, further comprising a main circuit board, a frame, and a rear cover; the optical sensor being electrically connected to the main circuit board through a flexible circuit board; the main circuit board, the optical sensor, and the display assembly being fixed to the frame; the rear cover being covered on the frame.
